Europäisches Patentamt

European Patent Office

Office européen des brevets

(11) Publication number: **0 154 871**
A2

# (12) EUROPEAN PATENT APPLICATION

(21) Application number: **85101986.9**

(22) Date of filing: **22.02.85**

(51) Int. Cl.⁴: **H 01 L 27/10**

(30) Priority: **12.03.84 JP 45467/84**

(43) Date of publication of application: **18.09.85**
Bulletin 85/38

(84) Designated Contracting States: **DE FR GB NL**

(71) Applicant: **HITACHI, LTD., 6, Kanda Surugadai 4-chome
Chiyoda-ku, Tokyo 100 (JP)**

(72) Inventor: **Yatsuda, Yuji, Sanraizucopo 202, 2-3-2 Fukuda,
Yamato-shi Kanagawa-ken (JP)**
Inventor: **Sunami, Hideo, 2196-421, Hirai Hinodemachi,
Nishitama-gun Tokyo (JP)**
Inventor: **Minato, Osamu, 2196-660, Hirai Hinodemachi,
Nishitama-gun Tokyo (JP)**
Inventor: **Aoki, Masakazu, 110-5, Shiro Ohaza,
Tokorozawa-shi Saitama-ken (JP)**
Inventor: **Takagi, Katsuaki, 2-22-15, Honcho,
Higashimurayama-shi Tokyo (JP)**
Inventor: **Horiguchi, Masashi, 4-14-6, Nishi-kiogakubo,
Kokubunji-shi Tokyo (JP)**
Inventor: **Tamura, Masao, 5-17-6, Nakaarai,
Tokorozawa-shi Saitama-ken (JP)**

(74) Representative: **Strehl, Schübel-Hopf, Schulz,
Widenmayerstrasse 17 Postfach 22 03 45,
D-8000 München 22 (DE)**

(54) One-transistor dynamic random-access memory.

(57) In a semiconductor memory having memory cells, a groove (17) is formed in a semiconductor substrate (10), and a semiconductor layer (20) is charged into said groove (17) via an insulating film (18) to form a capacitor electrode. The semiconductor layer (20) stretches on the insulating film (11) formed on the semiconductor substrate (10) and comes into contact with the substrate (10) passing through a hole formed in the insulating film (11) thereby to form a base portion of a switching MOS transistor. The source and drain regions (151, 152) of the transistor are formed on said semiconductor layer on the insulating film (11).

0154871

## Title of the Invention

TITLE MODIFIED
see front page

SEMICONDUCTOR MEMORY

## Background of the Invention

The present invention relates to a semiconductor memory and a process for the production thereof. More particularly, the invention relates to a one-transistor type dynamic MOS memory adapted to increasing the memory size and increasing the reliability and a process for the production thereof.

Since a dynamic random access memory (hereinafter referred to as DRAM) having a capacity of 1 Kb was first placed in the market in the early 1970s, as a semiconductor IC memory, the scale of a MOS dynamic memory has been quadrupled every about three years. However, a 16-pin dual inline package (DIP) has heretofore been chiefly used to contain the memory chip, imposing limitation on the cavity size for holding the chip. Namely, the package has been increased by as small as 1.4 times despite the increase in the scale of the memory. Therefore, the memory cell area of one bit which is a storage unit, has been greatly reduced with the increase in the scale of the memory; i.e., the memory cell area has been reduced to about one-third accompanying the increase in the scale of the memory.

The capacity C of capacitor in the memory cell is given by $C = \varepsilon A/t$ (where $\varepsilon$ denotes a permeability of the insulator, A denotes an area of the capacitor, and t denotes a thickness of the insulator). Therefore, if the area A is reduced to one-third, the capacity C is also reduced to one-third as far as $\varepsilon$ and t remain unchanged. The amount S of signals which is equivalent to a memory capacity varies in proportion to the amount Q of electric charge which is a product of the capacity C and the voltage V. Therefore, the amount Q of electric charge decreases with the decrease in the area A in proportion thereto, and the amount S of signals decreases correspondingly.

If noise is denoted by N, an S/N ratio decreases with the decrease in the amount S of signals, and a serious problem arises from the standpoint of circuit operation. Therefore, the reduction of area A has generally been compensated by reducing the thickness t. That is, as the scale of the memory increases from 4 Kb, through 16 Kb, 64 Kb, up to 256 Kb, the thickness of $SiO_2$ film which is a typical insulating film is reduced from 100 nm to 75 nm and even to 50 nm.

In recent years, furthermore, it has been confirmed that the electric charge of about 200 fC generates in the silicon substrate due to alpha particles radiated from heavy metals (uranium, thorium, and the like) contained in the package, giving rise to the occurrence of noise. Therefore, it is virtually difficult to reduce the amount $Q$ of electric charge which corresponds to the amount of signals, to smaller than about 200 fC, from the standpoint of preventing erroneous operation.

Therefore, it has been attempted to further reduce the thickness of the insulating film presenting, however, a problem of dielectric breakdown of the insulating film. The $SiO_2$ has a maximum dielectric strength voltage of $10^7$ V/cm. Therefore, the $SiO_2$ which is 10 nm thick is almost permanently broken down or is deteriorated when a voltage of 10 volts is applied thereto. Further, if long term reliability is taken into consideration, it is essential to drive the device on a voltage which is as smaller than a maximum breakdown voltage as possible.

Summary of the Invention

The object of the present invention is to provide a memory cell in which the thickness of the insulating film is not reduced even when the memory cell is formed in a small size, and in which the capacitor area A is maintained or is increased, in order to cope with serious problems such as disturbance induced by alpha particles, poor S/N rations, and reduced dielectric strength, that develop accompanying the reduction in the size of the memory cell.

First, according to the present invention, side walls of a groove engraved in a semiconductor substrate are used as an electrode surface of the capacitor in order to increase the area of electrode without increasing the plane area. This makes it possible to form a capacitor with a desired capacity without decreasing the thickness of the insulating film, i.e., without decreasing the dielectric strength of the insulating film.

Second, by forming a region for storing the electric charge of signals inside the groove, it is possible to prevent the occurrence of alpha- particle induced disturbance.

Third, the source and drain of a switching MOS transistor exist in a semiconductor layer (e.g., silicon layer) on an insulating film (e.g., $SiO_2$ film) formed on the silicon substrate, and the electrode for storing the electric charge in the groove is connected to the source or the drain on the insulating film (such as of $SiO_2$). Therefore, the alpha-particle induced disturbance is prevented from occurring not only for the memory cells but also for the bit lines (i.e., for a so-called bit line mode).

Fourth, the channel region of the switching MOS transistor is formed on the surface of the semiconductor layer (e.g., silicon layer) that is so formed as to come into direct contact with the semiconductor substrate (e.g., silicon substrate).

Thus, the switching $\overline{\text{MOS}}$ transistor is formed on the semiconductor layer (silicon layer) having good crystallinity, with the source and drain being formed on the insulating film (e.g., $SiO_2$ film) and the charge storage region being formed on the insulating film (e.g., $SiO_2$ film). Therefore, alpha-particle induced disturbance can be prevented from occurring, without sacrificing the performance for reading the data at high speeds.

Brief Description of the Drawings

Fig. 1 is a diagram showing a one-transistor type memory cell;

Fig. 2 is a diagram showing a DRAM of the open-bit line construction;

Fig. 3 is a diagram showing a DRAM of the folded-bit line construction;

Fig. 4 is a pattern diagram showing the memory cell layout of DRAM of the folded-bit line construction;

Fig. 5 is a section view along the line A-A of Fig. 4;

Fig. 6 is a pattern diagram showing the memory cell layout of DRAM according to an embodiment of the present invention;

Fig. 7 is a section view along the line B-B of Fig. 6;

Figs. 8, 9 and 10 are section views illustrating the steps in the process for producing memory cells according to the present invention; and

Fig. 11 is a section view showing the memory cell structure of DRAM according to another embodiment of the present invention.

Detailed Description of the Invention

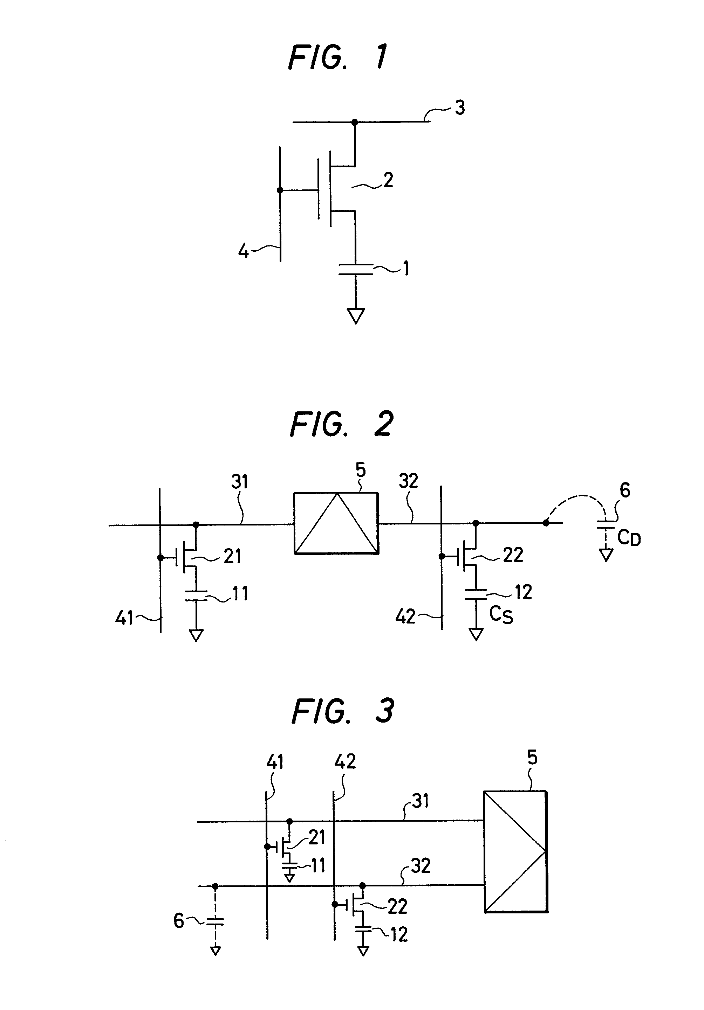

Fig. 1 shows the structure of a one-transistor type dynamic memory cell employing an insulated gate field effect transistor (hereinafter referred to as MOS transistor). The memory cell consists of a capacitor 1 for storing the electric charge and a switching MOS transistor 2. The drain of the switching transistor is connected to a bit line 3, and the gate thereof is connected to a word line 4.

Signal charges stored in the capacitor 1 are read by the switching transistor 2 to perform the operation. To practically constitute a memory of N bits, a memory array is formed by one of the methods which can be roughly divided into two as described below.

Fig. 2 shows a so-called open-bit line construction in which bit lines 31 and 32 are arranged on both sides of a sense amplifier 5 which takes out the signals in a differential manner. In this construction, only the bit line 31 electrically intersects a word line 41, and a difference of signals between the bit line 31 and the bit line 32 is detected by the sense amplifier 5.

Fig. 3, on the other hand, shows a folded-bit line construction in which two bit lines 31, 32 connected to the sense amplifier 5 are arranged in parallel, and the word line 41 intersects the two bit lines 31 and 32.

Although the embodiments of the invention that will be described later deal with the case of the folded-bit line construction, it should be noted that the invention is also applicable to the open-bit line construction.

In Figs. 2 and 3, if the capacity of parasitic capacitor 6 in the bit line 32 is denoted by $C_D$, and the capacity of a capacitor 12 in the memory cell is denoted by $C_S$, one of the major performance indicators of the memory array is represented by $C_S/C_D$. The S/N ratio of the memory array corresponds to $C_S/C_D$ in a one-to-one manner. Therefore, the S/N ratio can be increased if the capacity of the capacitor in the memory cell is increased and the capacity of the parasitic capacitor $C_D$ in the bit line is decreased.

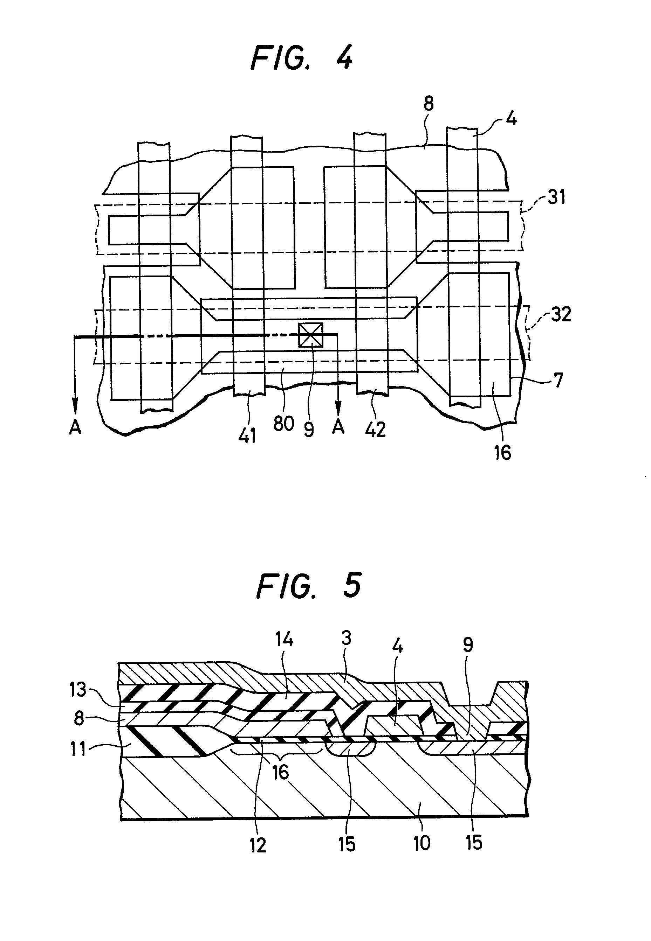

Fig. 4 is a plan view showing the layout of memory cells of the folded-bit line construction. Usually, a plate 8 is provided to form a capacitor in a portion of an active region 7 that is surrounded by a field oxide film having a thickness of greater than 100 nm. The plate is selectively removed (region 80) from a portion where the switching transistor will be formed and from a portion of contact hole 9 through which the bit line electrode will be connected to the drain on the silicon substrate. Word lines 41, 42 that serve as gates of the switching transistor are deposited on the region 80 to form the switching transistor 2. Fig. 5 is a section view along the line A-A of Fig. 4.

For the sake of convenient explanation, described below is the case where an n-channel type transistor is employed. When a p-channel type transistor is to be used, in general, the conductivity types of the silicon substrate and of the doped region should be reversed contrary to those of when the n-channel type transistor is used. In the conventional memory cell shown in Fig. 5, a field $SiO_2$ film 11 is selectively deposited to a thickness of about 100 to 1000 nm on a p-type silicon substrate 10 having a conductivity of about 10 ohms-cm by a so-called LOCOS method or the like using $Si_3N_4$ as an antioxidation mask. A gate oxide film 12 is deposited to a thickness of 10 to 100 nm on the silicon substrate 10 by the thermal oxidation process or the like. Then, a plate 8 as represented by polycrystalline silicon to which phosphorus or arsenic has been added, is selectively deposited, and is oxidized thereby to form a first intermediate insulating film 13. Thereafter, a word line (gate) 4 as represented by polycrystalline silicon, molybdenum silicide or a refractory metal (molybdenum or tungsten), is deposited, followed by the implantation of phosphorus ions or arsenic ions. Then, an $n^+$-type doped layer 15 is formed in an active region where neither the plate 8 nor the word line 4 has been deposited, so as to works as the source and drain of the switching MOS transistor 2. Then, a PSG 14 which contains phosphorus is deposited to a thickness of 500 to 1000 nm by a so-called CVD method, a contact hole 9 is formed in a portion where a bit line 3 as represented by an aluminum electrode will be connected to the doped layer 15, and the bit line 3 is selectively deposited.

In this memory cell, a region 16 of the capacitor 1 that serves as a storage capacity is represented by a hatched portion in Fig. 4. The region 16 decreases with the decrease in the size of the memory cell. Therefore, unless the thickness of the gate oxide film 12 is reduced, the capacity $C_S$ of the capacitor decreases as mentioned earlier to seriously hinder the operation of the memory.

In the above description, the $SiO_2$ film 12 was used as the insulating film under the plate 8 and the word line 4 (or gate of the switching transistor 2). In order to increase the capacity $C_S$ of the capacitor, however, the insulating film under the plate 8 may be composed of either $SiO_2$ or $Si_3N_4$. Or, both of them may be used to form insulating films of one-layer to three-layer structure.

The object of the present invention is to realize the construction which is capable of increasing the capacity $C_S$ without increasing the plane area, and which permits little the occurrence of alpha-particle induced disturbance for the memory cell and for the bit line, while eliminating the aforementioned defects inherent in the conventional construction.

In order to solve the aforementioned problems, there has been proposed by Sunami et al., the inventors of the present invention, a memory in which a groove is formed in the silicon substrate, and a storage capacity of the memory cell is formed by utilizing side walls of the groove (U.S. Patent Application Serial No. 465341, European Patent Application Publication No. 0 085 988

A semiconductor memory of the present invention is concerned with an improved construction of the grooved capacitor memory.

## Embodiments

Embodiments of the invention will be described below in detail.

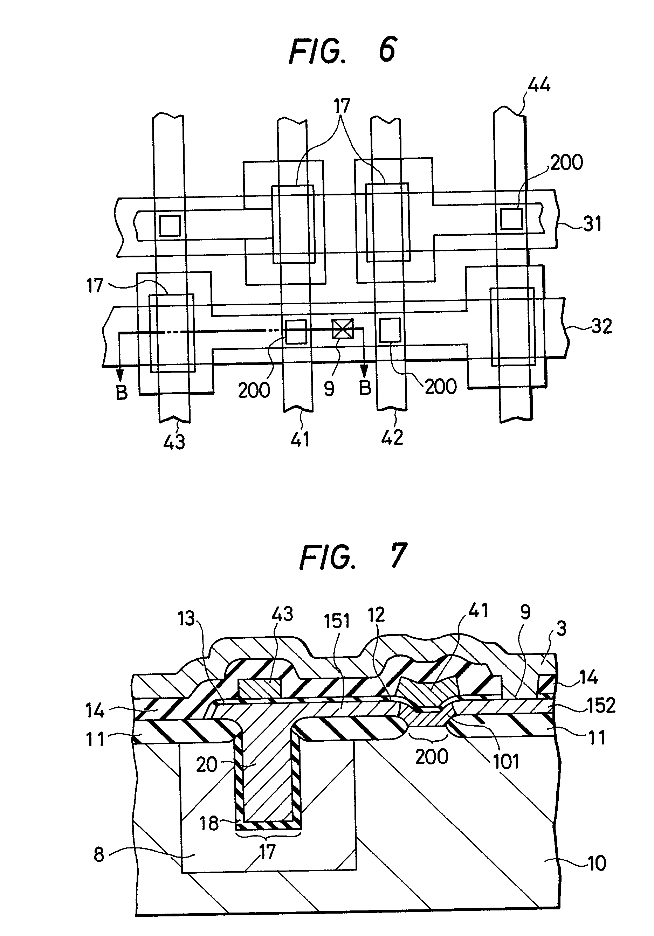

Fig. 6 is a plan view showing the layout of memory cells according to an embodiment of the present invention, and Fig. 7 is a section view of a portion along the line B-B of Fig. 6.

This memory cell is different from the conventional memory cell of Fig. 4 with respect to the below-mentioned points. First, a small-resistance layer 8 is provided in a region which includes major portions of side walls of a groove 17 engraved in a silicon substrate 10. The small-resistance layer 8 works as a plate. A silicon layer 20 charged into the groove via an insulating film (such as of $SiO_2$) 18 is utilized as a capacitor electrode. Second, the capacitor electrode 20 charged into the groove and the switching transistor are formed by the same silicon layer, the one side 151 of $n^+$-type layer of the switching transistor being formed as a unitary structure together with the capacitor electrode 20 and the other side 152 thereof being composed of a silicon layer 152 which is connected to the bit line 3 and which is formed on an insulating film 11. Further, the channel portion of the switching transistor, i.e., a silicon layer 101 in a region under the gate electrode 41 is brought into direct contact with the silicon substrate 10 on the lower side.

Described below in detail are the steps for producing semiconductor memories according to the present invention.

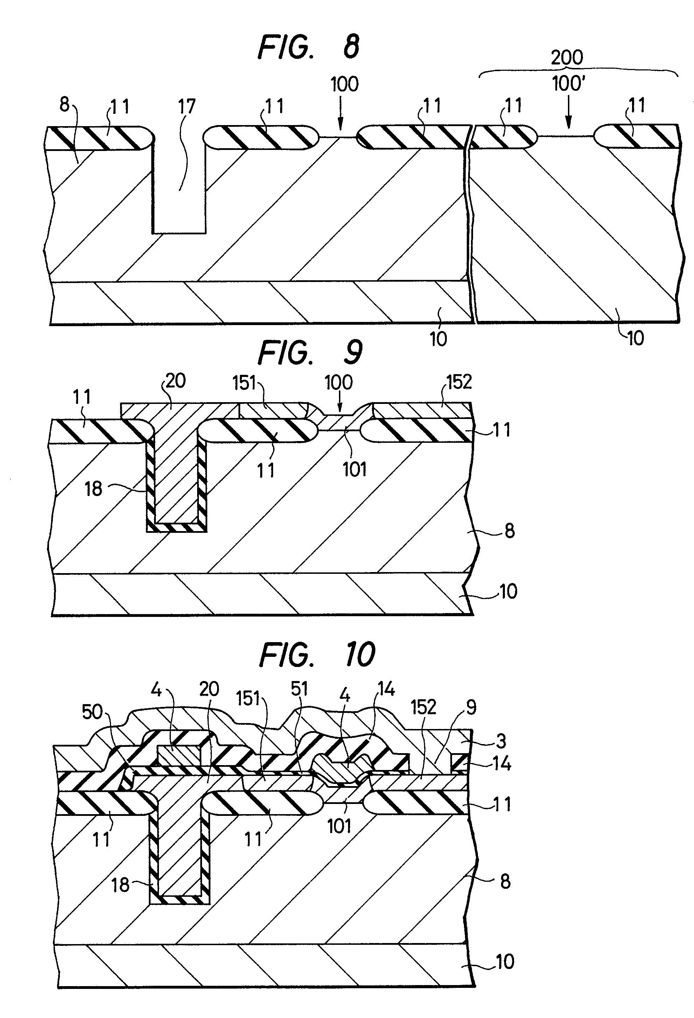

As shown in Fig. 8, a $p^+$-type layer 8 is selectively formed by a well-known diffusion method or the like on a region where a memory array is to be formed in a p-type silicon substrate 10 having a conductivity of 1 to 20 ohms-cm, the $p^+$-type layer 8 having the same type of conductivity as the silicon substrate and having a conductivity of smaller than one ohm-cm. Then, the field oxide film 11 is formed by the LOCOS method mentioned earlier, and the groove 17 of a predetermined size is formed by the parallel plate plasma etching using a gas composed chiefly of $SF_6$ or $CCl_4$ which contains fluorine or chlorine. The groove is usually etched to a depth of 1 to 5 µm. A pattern of groove is once transferred onto an $SiO_2$ film or the like formed by the CVD method using an ordinary photoresist, and the groove 17 is formed using the film formed by the CVD method as a mask. In order to reduce the cell area, the mask covers the regions where other active elements will be formed, i.e., covers the regions where no groove will be formed, and further covers regions 100, 100' where there exists no thick oxide film 11 formed by the LOCOS method. The groove is formed being self-aligned with the oxide film formed by the LOCOS method. Elements of peripheral circuits other than the memory array are formed in a region 200 on the silicon substrate 10. This step, however, is not referred to in the description related to Fig. 9 and subsequent drawings.

Then, as shown in Fig. 9, a capacitor insulating film 18 represented by a single layer of $SiO_2$ or $Si_3N_4$ or a composite film thereof, or $Ta_2O_5$, is formed at least inside the groove. The insulating film is removed from the predetermined region 100 on the surface of the silicon substrate, and a p-type silicon layer is formed to a thickness of about 0.3 μm by the epitaxial method. The groove 17 can be completely filled up with the silicon layer if its thickness is greater than one-half the distance between the inner walls of the groove 17, as shown in Fig. 9. In this case, a single-crystalline silicon layer is formed on a region 101 to come into direct contact with the silicon substrate, and polycrystalline silicon layers 20, 151, 152 are formed on other $SiO_2$ layers. Thereafter, the annealing is effected at a temperature of higher than 1000°C for a short period of time in order to improve characteristics of the regions where the single-crystalline silicon layer 101 and polycrystalline silicon layers 151, 152 are contacted.

An $n^+$-type layer 20 is formed by the selective doping of phosphorus ions or arsenic ions including at least the silicon layer buried into the groove but excluding the region 101 where the switching MOS is to be formed.

Then, as shown in Fig. 10, an oxide film (first intermediate insulating film) 50 which is as relatively thick as 0.1 to 0.2 μm is formed on the $n^+$-type layer 20 by the dry or wet oxidation method conducted at 800° to 1100°C. A gate oxide film 51 which is 10 to 50 nm thick is formed on the silicon layer 101 where the switching transistor is to be formed, and a gate (word line 4) composed of polycrystalline silicon, molybdenum silicide, molybdenum, tungsten, or the like, is deposited thereon.  Arsenic ions or the like ions are then implanted by the ion implantation method, in order to form $n^+$-type doped layers 151, 152.

Thereafter, a second intermediate insulating film 14 as represented by the CVD PSG is deposited to form a contact hole 9 which leads to the $n^+$-type diffusion layer, and a bit line 3 represented by aluminum is deposited.

The capacitor 1 is then formed by the capacitor insulating film 18 and by the two electrodes, i.e., the capacitor electrode 20 and the plate 8 between which the capacitor insulating film 18 is sandwiched.  If the plate 8 is of the p-type which is the same as that of the silicon substrate 10, the capacitor electrode 20 assumes a positive potential. Therefore, it is necessary to maintain a sufficiently high concentration of p-type impurities so that the surface of the plate 8 will not be depleted or so that an inverted layer will not be formed at a maximum potential.

In this embodiment, the silicon substrate 10 is of the p-type, the plate 8 is of the $p^+$-type, and the memory array is formed on the whole surface of the plate 8.  As shown in Fig. 7, however, the plate 8 may be formed only about the groove.  It is also allowable, as a matter of course, to employ the substrate 10 of the n-type, and the plate 8 of the $p^+$-type, or the plate 8 of the $n^+$-type. Further, an epitaxial substrate such as $p^+/p$, $n^+/n$, $p^+/n$, or $n^+/p$ may be used as the silicon substrate.

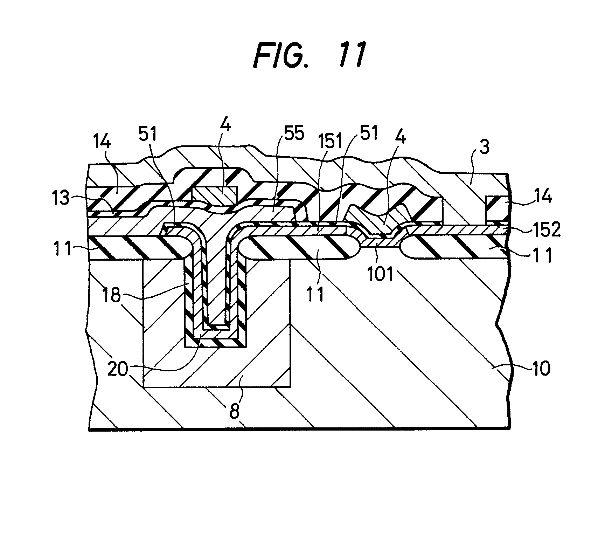

Fig. 11 shows another embodiment of the present invention. The capacitor electrode 20 is forming a capacitor 1 between itself and the plate 8. In this embodiment, furthermore, a second plate 55 is deposited via the first intermediate insulating film 51, thereby to form another capacitor. Therefore, the capacitor formed in addition to the capacitor formed between the electrode 20 and the plate 8, contributes to obtain a capacitor of a large capacity. Depending upon the cases, furthermore, thickness of the insulating film 18 may be increased between the capacitor electrode 20 and the plate 8 to use only the capacitor which is formed between the capacitor electrode 20 and the plate 55. The second plate 55 which assumes ground potential also works as a shield for the capacitor electrode 20 to protect the memory cell from the noise.

In the above-mentioned embodiment, a hole 200 in the silicon layer which is in direct contact with the silicon substrate 10, has been shown in Fig. 6 to be located inside the word line 4 and the silicon layer. In practice, however, there will be no problem even if the hole 200 is located slightly on the outside. An optimum layout can be selected depending upon the manufacturing conditions. The important point is that a major portion of $n^+$-type layer of the switching MOS is formed on the $SiO_2$ layer, and a major portion of the channel is formed on the silicon layer that is in contact with the silicon substrate.

According to the present invention as explained in the foregoing, it is possible to realize a memory cell which does not sacrifice characteristics of the switching MOS transistor, which exhibits a large capacity of capacitor and which permits very little the occurrence of alpha-particle induced disturbance.

CLAIMS:

1.   A semiconductor memory comprising a capacitor (1) having a data storage portion, and a switching insulated gate field-effect transistor (2), wherein said capacitor (1) has a main portion of capacitor electrode (20) which is electrically connected to the source or the drain of said field-effect transistor (2), said main portion being formed in a groove (17) provided in a semiconductor substrate (10), said field-effect transistor (2) having a region (101) in direct contact with the semiconductor substrate (10) and another region (151,152) formed in a second semiconductor layer disposed on an insulating film (11), said field-effect transistor further having main regions of the source and drain in the regions (151, 152) of said second semiconductor layer formed on said insulating film (11), and a main region of the channel formed on a region of said second semiconductor layer (101) that is in direct contact with the semiconductor substrate (10).

2.   The semiconductor memory of claim 1, wherein a surface concentration of the semiconductor substrate (10) is greater than $10^{17}$ $cm^{-3}$ in a region where a memory cell will be formed.

3.    The semiconductor memory of claim 1 or 2,
wherein said semiconductor substrate (10) is composed
of silicon, and said second semiconductor layer (151,
152) consists of a silicon layer formed by the
epitaxial method.

4.    The semiconductor memory of claim 1 or 2,
wherein said semiconductor substrate (10) is composed
of silicon, and said second semiconductor layer (151,
152) consists of a layer that is formed by depositing
polycrystalline silicon and partially crystallizing
the polycrystalline silicon  by annealing.

PS/JG

0154871

FIG. 1

FIG. 2

FIG. 3

FIG. 4

FIG. 5

## FIG. 6

## FIG. 7

## FIG. 8

## FIG. 9

## FIG. 10

FIG. 11